Europäisches Patentamt

European Patent Office

Office européen des brevets

(19)

(11) Veröffentlichungsnummer: **0 099 142**
**B1**

(12) **EUROPÄISCHE PATENTSCHRIFT**

(45) Veröffentlichungstag der Patentschrift: 05.09.90

(51) Int. Cl.⁵: **H 03 D 3/00**

(21) Anmeldenummer: **83200894.0**

(22) Anmeldetag: **20.06.83**

(54) **Verfahren und Anordnung zum Demodulieren eines frequenzmodulierten Eingangssignals.**

(30) Priorität: **23.06.82 DE 3223345**

(43) Veröffentlichungstag der Anmeldung:
**25.01.84 Patentblatt 84/04**

(45) Bekanntmachung des Hinweises auf die
Patenterteilung:
**05.09.90 Patentblatt 90/36**

(84) Benannte Vertragsstaaten:
**AT DE FR GB IT**

(56) Entgegenhaltungen:
**EP-A-0 028 404**
**EP-A-0 049 059**
**GB-A-2 080 073**

**PATENTS ABSTRACTS OF JAPAN, Band 6, Nr.
21 (E-93)899r, 6. Februar 1982; & JP - A - 56 140
706 (NIPPON DENSHIN DENWA KOSHA)
04.11.1981**

(73) Patentinhaber: **Philips Patentverwaltung GmbH
Wendenstrasse 35 Postfach 10 51 49
D-2000 Hamburg 1 (DE)**
(84) **DE**

(73) Patentinhaber: **N.V. Philips'
Gloeilampenfabrieken
Groenewoudseweg 1
NL-5621 BA Eindhoven (NL)**
(84) **FR GB IT AT**

(72) Erfinder: **Demmer, Walter
Sorthmannweg 15
D-2000 Hamburg 54 (DE)**
Erfinder: **Gutsmann, Rolf-Dieter
Greickstrasse 4A
D-2000 Hamburg 54 (DE)**
Erfinder: **Bergs, Norbert
Wiesinger Weg 34
D-2000 Hamburg 54 (DE)**
Erfinder: **Heinemann, Ingolf
Vogtshof 6
D-2000 Hamburg 62 (DE)**
Erfinder: **Warmuth, Leo
Osterstrasse 156
D-2000 Hamburg 19 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# EP 0 099 142 B1

(74) Vertreter: **Poddig, Dieter, Dipl.-Ing. et al**
**Philips Patentverwaltung GmbH Wendenstrasse**
**35 Postfach 10 51 49**
**D-2000 Hamburg 1 (DE)**

**Beschreibung**

Die Erfindung bezieht sich auf ein Verfahren zum Demodulieren eines frequenzmodulierten periodischen Eingangssignals gemäß dem Oberbegriff des Hauptanspruchs sowie eine Anordnung zur Durchführung des Verfahrens.

Ein Verfahrens für rein analog vorliegende Eingangssignale ist bekannt, wobei die Dauer jeder Halbperiode zwischen jeweils zwei benachbarten Nulldurchgängen durch das Auszählen eines Referenz-Taktsignals bestimmt wird, dessen Frequenz hoch im Vergleich zu der höchsten Frequenz des Eingangssignals ist. Die Anzahl der zwischen zwei benachbarten Nulldurchgängen gezählten Impulse des Referenz-Taktsignals geben die Dauer der Halbperiode digital an. Wenn die Dauer der Halbperiode mit hoher Auflösung bestimmt werden soll, muß die Frequenz des Referenz-Taktsignals entsprechend über der Frequenz des Eingangssignals liegen. Bei Eingangssignalen mit hoher Frequenz, beispielsweise dem frequenzmodulierten Luminanzsignal eines von einem Magnetband abgelesenen Farbbildsignals, ist dann ein derart hochfrequentes Referenz-Taktsignal notwendig, daß hierfür keine oder nur sehr aufwendig und teure Zählanordnungen zur Verfügung stehen.

Aus der EP—A—0 049 059 ist ein Decodierer für ein PCM-codiertes Telefonsignal bekannt, vgl. die dortige Beschreibung, Seite 1, Zeilen 3 und 6. Wie ferner auf der dortigen Seite 1, insb. in den Zellen 18 bis 20, ausgeführt wird, werden bei einer derartigen PCM-Codierung zwei Frequenzen im Audiosignalbereich nahe 1 KHz übertragen. Der beschriebene Decodierer muß dann zur Decodierung des PCM-Signals diese beiden Frequenzen voneinander unterscheiden können. Im Gegensatz zu einer "echten" Frequenzdemodulation muß der Decodierer somit lediglich erkennen, ob eine übertragene Frequenz unterhalb oder oberhalb eines Referenzwertes liegt. Entsprechend liefert die bekannte Schaltungsanordnung am Ausgang des dortigen Komparators mit dem Bezugszeichen 25 ein binäres Signal von Pegel "0", wenn die ermittelte Periodendauer des PCM-Signals den Referenzwert überschreitet, und ein Signal vom Pegel "1", wenn die Periodendauer des PCM-Signals kleiner oder gleich dem Referenzwert ist.

Bei dem Verfahren nach dem Gattungsbegriff liegen die Frequenzen der erforderlichen Takt- oder anderen Hilfssignale nur in der Größenordnung der Frequenz, mit der die Folge der Abtastwerte des Eingangssignals auftritt, so daß digitale elektronische Schaltungen mit niedriger Verarbeitungsgeschwindigkeit engesetzt werden können.

Dabei wird die Dauer jeder Halbperiode aus ganzen Perioden T der Abtastwerte sowie aus Bruchteilen davon bestimmt, die durch lineare Annäherung des Eingangssignals im Bereich der Nulldurchgänge aus den beiden benachbarten Abtastwerten gewonnen werden. Die Auflösung bei der Bestimmung der Dauer jeder Halbperiode wird dabei nicht durch ein hochfrequentes Taktsignal, sondern durch die Auflösung gegeben, d.h. die Stellenzahl, mit der die Abtastwerte vorliegen. Die dabei erforderliche Berechnung kann innerhalb der Zeitabstände zweier aufeinanderfolgender Abtastwerte bzw. bei mehreren Rechenschritten in einem Vielfachen davon durchgeführt werden, wenn eine sogenannte Pipeline-Struktur bei der Realisierung des Verfahrens angewendet wird. Der zweite Zeitabschnitt $t_m$ kann bei der Berechnung der Dauer der nächsten Halbperiode als erster Zeitabschnitt $t_n$ verwendet werden.

Die Dauer einer Halbperiode wird jeweils mit dem ersten Abtastwert nach dem Ende dieser Halbperiode, d.h. nach dem diese Halbperiode beendenden Nulldurchgang, ermittelt. Der dabei ermittelte Wert wird so lange aufrechterhalten, bis die Dauer der nächsten Halbperiode bestimmt ist. Das bedeutet, daß der Wert für die Dauer einer Halbperiode jeweils für die Länge der folgenden Halbperiode aufrechterhalten wird, deren Dauer jedoch von der der vorhergehenden Halbperiode abweichen kann, so daß die Werte kurzer Dauern von Halbperioden zu lange und umgekehrt aufrechterhalten werden und sich somit eine Verschiebung gegenüber dem korrekten demodulierten Signal ergibt.

Die Erfindung hat die Aufgabe, eine möglichst unverfälschte Ermittlung und Weiterleitung der im modulierten Signal enthaltenen Information zu gewährleisten. Dazu sollen außer einer Bestimmung der Nulldurchgänge des frequenzmodulierten Signals und damit der Periodendauern bzw. der Dauern der Halbperioden mit möglichst hoher Genauigkeit die ermittelten Werte der Dauern der Halbperioden des frequenzmodulierten Signals und damit die ermittelten Werte für die Momentanfrequenz des frequenzmodulierten Signals möglichst genau über Zeiträume entsprechend diesen ermittelten Halbperiodendauern zur weiteren Verarbeitung und Auswertung zur Verfügung gestellt werden.

Zur Lösung dieser Aufgabe werden erfindungsgemäß die Kehrwerte der Dauern der Halbperioden gebildet und wird die ermittelte Dauer jeder Halbperiode einen Zeitabschnitt gleich dem Abstand einer Anzahl Abtastwerte aufrechterhalten wird, die um 1 größer als die Anzahl der Abtastwerte zwischen dem ersten der beiden benachbarten Nulldurchgänge und dem vorhergehenden Nulldurchgang ist. Das so ausgestaltete Verfahren kann auf einfache Weise mit Hilfe einer Verzögerungseinrichtung durchgeführt werden, wie später noch erläutert wird.

Die Genauigkeit der Annäherung eines sinusförmigen Eingangssignals durch eine Gerade im Bereich der Nullstellen ist um so größer, je mehr Abtastwerte innerhalb einer Halbperiode liegen, wie leicht einzusehen ist. Falls jedoch nur wenige Abtastwerte, z.B. weniger als zwei, innerhalb einer Halbperiode des Eingangssignals liegen, entsteht durch die lineare Annäherung ein merklicher Fehler. In diesem Falle ist es nach einer Ausgestaltung des erfindungsgemäßen Verfahrens zweckmäßig, daß jeder Zeitabstand, $t_n$, $t_m$ vor der Bestimmung der Dauer der Halbperiode um einen vom Wert dieses Zeitabstandes abhängigen Korrekturwert korrigiert wird. Für eine weitergehende Korrektur könnte außerdem noch der Wert für die Dauer der vorhergehenden Halbperiode mit herangezogen werden, weil allgemein davon ausgegangen werden kann, daß sich die in dem Eingangssignal enthaltene Frequenz von einer Halbperiode auf die nächste nicht sprunghaft ändert.

Bei der vorstehend angegebenen Ausgestaltung des erfindungsgemäßen Verfahrens entstehen jedoch immer noch kleine Fehler durch Zeitverschiebungen, da der Wert für die Dauer einer Halbperiode jeweils mit dem Auftreten eines Abtastwertes zusammenfällt oder gegebenenfalls eine konstante Verschiebung dazu hat, während der tatsächliche Nulldurchgang zu einem beliebigen Zeitpunkt zwischen zwei Abtastwerten auftritt. Um die Auswirkungen dieses statistisch schwankenden Zeitfehlers zu verringern, ist es nach einer weiteren Ausgestaltung des erfindungsgemäßen Verfahrens zweckmäßig, daß dem Zeitabschnitt zwischen den aufeinanderfolgenden Abtastwerten $a_n$, $a_{n+1}$ im Bereich des ersten der beiden Nulldurchgänge eine Periodendauer $_{nk}$ zugeordnet wird, die abhängig von dem Zeitabschnitt $t_n$ zwischen diesem Nulldurchgang und dem vorhergehenden Abtastwert zwischen der vor diesem Nulldurchgang ermittelten Periodendauer $\tau_{n-1}$ und der zuletzt ermittelten Periodendauer $\tau_n$ gemäß folgender Beziehung liegt:

$$\tau_{nk} = t_n \left(\tau_{n-1} - \tau_n\right) + \tau_n.$$

Auf diese Weise wird bei dem Übergang von dem Wert der Dauer einer Halbperiode zu dem der nächsten Halbperiode ein Zwischenwert im Bereich des Nulldurchganges eingeschoben, so daß ein geglätteter Verlauf der Werte eine sehr gute Annäherung an den Verlauf der Frequenz des Eingangssignals ergibt.

Eine Anordnung zur Durchführung des erfindungsgemäßen Verfahrens sowie Ausgestaltungen davon sind in den weiteren Unteransprüchen gekennzeichnet.

Ausführungsbeispiele der Erfindung werden nachstehend anhand der Zeichnung näher erläutert. Es zeigen

Fig. 1 ein Zeitdiagramm zur Erläuterung der Bestimmung der Dauer von Halbperioden eines frequenzmodulierten sinusförmigen Eingangssignals durch Annäherung der Nulldurchgänge mittels Geraden,

Fig. 2 ein Diagramm zur Erläuterung von dabei auftretenden Fehlern,

Fig. 3 die Auswirkungen, die dadurch entstehen, daß der Wert Dauer einer Halbperiode während der Zeitdauer der folgenden Halbperiode aufrechterhalten wird, sowie die Auswirkung der Korrektur dieses Effektes,

Fig. 4 ein Blockdiagramm einer erfindungsgemäßen Schaltungsanordnung,

Fig. 5 das Blockdiagramm einer Erweiterung der Schaltungsanordnung nach Fig. 4,

Fig. 6 den grundsätzlichen Aufbau bestimmter Verzögerungsstufen.

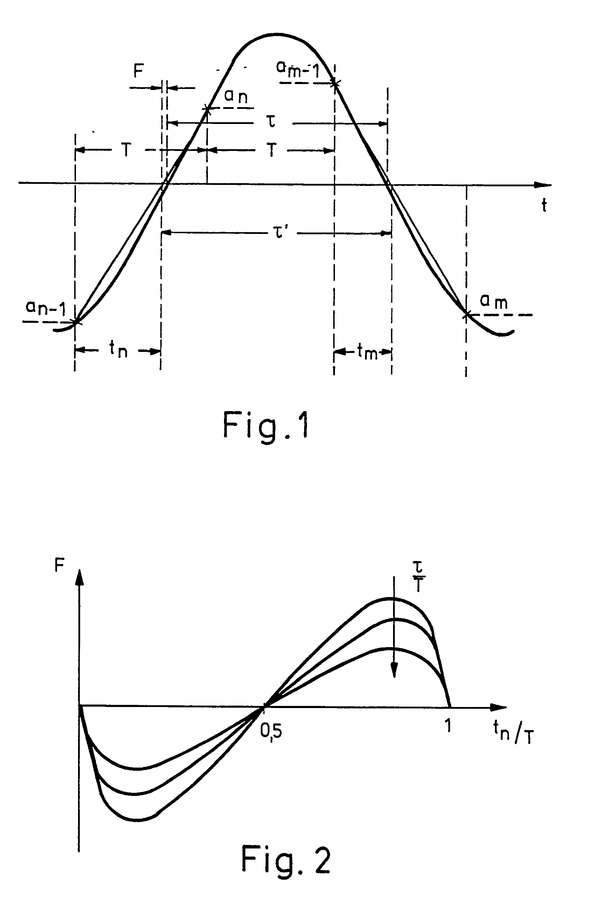

In Fig. 1 ist eine volle Schwingung eines sinusförmigen Signals aufgetragen, von dem die Dauer $\tau$ einer Halbperiode mit digitalen Mitteln bestimmt werden soll. Dafür liegt das Eingangssignal als Folge von Abtastwerten vor, von denen die Abtastwerte $a_{n-1}$, $a_n$, $a_{m-1}$, $a_m$ dargestellt sind. Wenn die Abtastwerte im Verhältnis zum Signal enger liegen, d.h. wenn die Frequenz des Signals niedrig im Verhältnis zur Frequenz der Abtastwerte entsprechend $1/T$ ist (T ist die Periode der Abtastwerte, d.h. der Abstand zweier aufeinanderfolgender Abtastwerte), liegen zwischen den Abtastwerten $a_n$ und $a_{m-1}$ noch weitere Abtastwerte. Dies ist für die folgende Erläuterung jedoch nicht von besonderer Bedeutung.

Die Nulldurchgänge des Signals bestimmen die Dauer der Halbperiode und damit dessen Frequenz. Da jedoch nur zeitdiskrete Abtastwerte vorliegen, werden die Nulldurchgänge durch eine gerade Verbindung der beiden benachbarten Antastwerte angenähert und aus den Zeitabschnitten, die die Kreuzungen dieser annähernden Geraden mit der Achse bilden, ein angenäherter Wert $\tau'$ der gesuchten Periodendauer gebildet. Aus den Zeitabschnitten $t_n$ und $t_m$ zwischen jeweils einem Kreuzungspunkt einer annähernden Gerade und dem vorhergehenden Abtastwert sowie aus der Anzahl n der Abtastwerte zwischen zwei benachbarten Nulldurchgängen läßt sich dann gemäß Fig. 1 der angenäherte Wert für die Dauer einer Halbperiode wie folgt bestimmen:

$$\tau' = (T - t_n) + n.T + t_m$$
$$= t_m - t_n + (n+1)T \qquad (1)$$

Die Dauer des Zeitabschnittes $t_n$ ergibt sich aus den Werten $a_{n-1}$ und $a_n$ der beiden benachbarten Abtastwerte sowie aus deren Abstand T nach dem Strahlensatz auf folgende Weise:

$$\frac{t_n}{|a_{n-1}|} = \frac{T}{|a_{n-1} - a_n|}$$

$$t_n = \frac{|a_{n-1}|}{|a_{n-1} - a_n|} \cdot T \qquad (2)$$

4

In entsprechender Weise ergibt sich die Dauer des Zeitabschnittes $t_m$. Diese Zeitabschnitte können nacheinander ermittelt werden, wobei der zunächst ermittelte Zeitabschnitt $t_n$ zwischengespeichert wird, und aus dem zwischengespeicherten Zeitabschnitt $t_n$ und dem momentan errechneten $t_m$ wird nach Gleichung (1) der angenäherte Wert $\tau'$ der Dauer der Halbperiode bestimmt.

Wie aus Fig. 1 ferner zu erkennen ist, weicht der Kreuzungspunkt der durch die beiden benachbarten Abtastwerte verlaufenden annähernden Geraden mit der Achse von dem tatsächlichen Nulldurchgang des Signals um einen Fehler F ab. Dieser Fehler hängt, wie aus Fig. 1 leicht abzuleiten ist, von der Lage der beiden Abtastwerte im Verhältnis zum Nulldurchgang und damit auch unmittelbar von dem Wert des Zeitabschnittes $t_n$ ab. Wenn ein Abtastwert zufällig mit einem Nulldurchgang zusammenfällt, d.h. $t_n = 0$ oder $t_n = T$, ist der Fehler auch gleich 0. Wenn die beiden Abtastwerte genau symmetrisch zum Nulldurchgang liegen, d.h. $t_n = 0,5$, ist der Fehler bei einem rein sinusförmigen Signal ebenfalls gleich 0, wobei der Fehler zu beiden Seiten von diesem Wert für $t_n$ unterschiedliche Vorzeichen hat.

Der Verlauf des Fehlers F in Abhängigkeit von dem Verhältnis des Zeitabschnittes $t_n$ zur Periode T der Abtastwerte ist in Fig. 2 ausgetragen. Je dichter die Abtastwerte im Verhältnis zur Periode des Signals liegen, d.h. je größer der Wert $\tau/T$ ist, desto kleiner wird der maximale Wert des Fehlers F, wobei der grundsätzliche Verlauf in Abhängigkeit der Lage der Abtastwerte zum Nulldurchgang jedoch ähnlich ist. Für eine sehr genaue Korrektur der Zeitabschnitte $t_n$ bzw. $t_m$ müßte also die momentane Frequenz bzw. Periodendauer des Signals bekannt sein, die durch die entsprechenden, zuletzt bestimmten Werte angenähert werden können unter der Annahme, daß keine große sprunghafte Änderung der Frequenz des Signals zwischen zwei Halbperioden erfolgt. In praktischen Fällen, beispielsweise bei der Demodulation des frequenzmodulierten Luminanzsignals eines von einem Magnetband abgelesenen Bildsignals hat es sich jedoch herausgestellt, daß die Korrektur der Zeitabschnitte $t_n$ und $t_m$ nur abhängig von diesen Werten für eine mittlere Frequenz des Signals, die gleich einem Viertel der Frequenz der Abtastwerte ist, ausreicht. Wenn mit den so korrigierten Zeitabschnitten die Dauer $\tau$ einer Halbperiode des Signals und daraus dessen Momentanfrequenz ermittelt wird, ergeben sich diese mit ausreichender Genauigkeit.

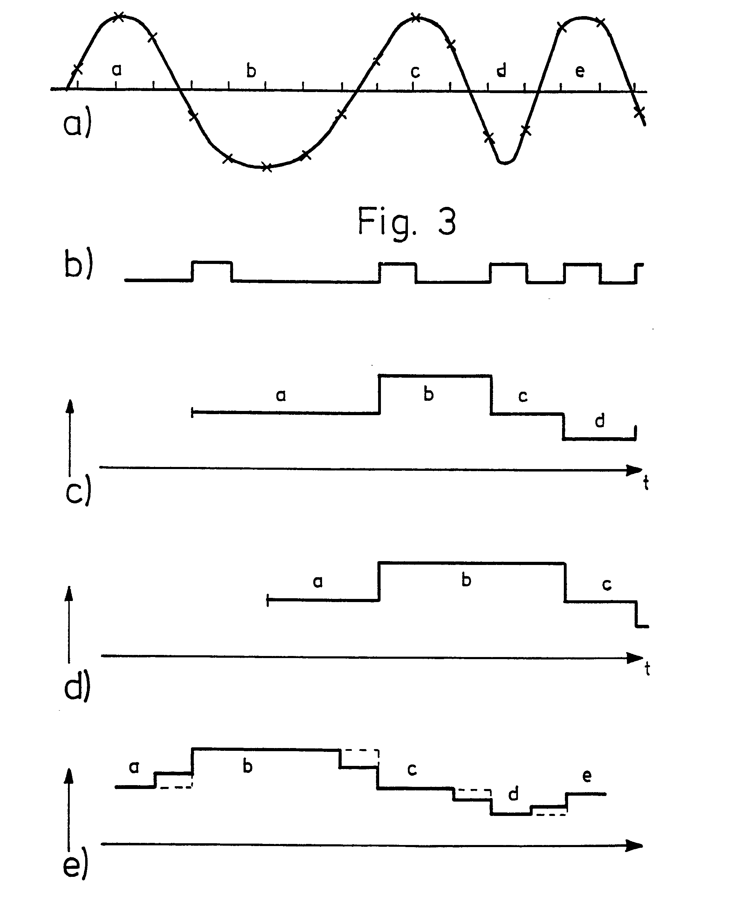

Auf diese Weise sind aber zunächst nur die Werte der Dauern der einzelnen Halbperioden bestimmt worden, die jedoch noch nicht unmittelbar den korrekten Verlauf der Periodendauern der Frequenz des Signals wiedergeben, wie anhand der Fig. 3 erläutert wird. Darin ist in der Zeile a) ein Eingangssignal dargestellt, dessen Frequenz sich übertrieben schnell ändert. In der Zeile b) ist das Nulldurchgangssignal dargestellt, das erzeugt wird, wenn unmittelbar nach einem Abtastwert ein neuer Abtastwert mit entgegengesetztem Vorzeichen auftritt, und dieses Signal wird aufrechterhalten bis zum danach folgenden Abtastwert. Der Verlauf des Nulldurchgangssignals ist auch für die später folgende Erläuterung eines Blockschaltbildes von Bedeutung.

Mit dem ersten, in Zeile b) der Fig. 3 dargestellten Nulldurchgangssignal wird der Wert der Dauer der Halbperiode a des Eingangssignals bestimmt. Dieser Wert wird aufrechterhalten bis zum zweiten Nulldurchgangssignal, bei dem der Wert der Dauer der Halbperiode b bestimmt wird. Entsprechend gilt dies für die Halbperioden c und d ebenfalls. Die Werte $\tau_n$ der Dauern dieser einzelnen Halbperioden und die Zeitdauern, die diese Werte aufrechterhalten werden, sind in Fig. 3 in der Zeile c) dargestellt, wobei der Beginn des Wertes für die Dauer der Halbperiode a durch einen kleinen senkrechten Strich markiert wurde, da die vorhergehende Halbperiode des Eingangssignals und damit dessen Dauer nicht dargestellt ist.

Daraus läßt sich erkennen, daß die Werte für die Dauern der einzelnen Halbperioden während Zeitperioden aufrechterhalten werden, deren Dauer nicht der Dauer der zugehörigen Halbperiode entspricht. Um einen genaueren Verlauf anzunähern, muß die Zeitdauer, während der der Wert der Dauer jeweils einer Halbperiode aufrechterhalten wird, verändert werden, was durch Verzögern dieser Werte um mehrere Perioden des Abtasttaktes erfolgen kann. Dabei müssen verschiedene Werte teilweise unterschiedlich verzögert werden. Die Steuerung der Verzögerung kann dabei von dem Nulldurchgangssignal abgeleitet werden. Die durch Verzögerung auf die richtige Dauer gebrachten Werte $\tau_v$ sind in der Zeile d) in Fig. 3 dargestellt. Die Folge dieser Werte gibt mit wesentlich größerer Annäherung den tatsächlichen Verlauf der Periodendauern des Eingangssignals wieder.

In Zeile e) in Fig. 3 ist die Folge der Werte für die Dauern der einzelnen Halbperioden a bis e so verschoben dargestellt, daß der Wert für die Dauer jeweils einer Halbperiode mit dem ersten Abtastwert in dieser Halbperiode beginnt. Es ist zu erkennen, daß damit immer noch eine gewisse Verschiebung jedes Wertes der Dauer einer Halbperiode gegen die genaue Lage dieser Halbperiode selbst vorhanden ist, da bei dem gewählten Beispiel die Nulldurchgänge zwischen jeweils zwei Abtastwerten liegen. Die Verschiebung des Anfanges jeweils eines neuen Wertes gegenüber dem ersten der beiden zugehörigen benachbarten Nulldurchgänge ist jedoch vom Eingangssignal abhängig und schwankt damit statistisch, so daß auch eine beliebige andere Verschiebung der Folge von Werten (wobei diese Verschiebung hier rein zeichnerisch ist und einem beliebigen konstanten Versatz zwischen Eingangssignal und Ausgangssignal entspricht) die Folge von Werten niemals vollständig in Übereinstimmung mit dem Eingangssignal bringen kann.

Um die Annäherung weiter zu verbessern, wird jeweils vor einem neuen Wert, d.h. hier zeichnerisch zwischen den beiden Abtastwerten zu beiden Seiten des Nulldurchganges, ein Zwischenwert zwischen dem alten und dem neuen Wert gebildet, der von der Lage des Nulldurchganges zwischen den Zeitpunkten der Abtastwerte und damit von den Werten der Zeitabstände $t_n$ bzw. $t_m$ bei der Bestimmung der Dauern der Halbperioden auf folgende Weise abhängt:

5

$$\tau_z = t_n \cdot \tau_{n-1} + (1-t_n)\tau_n$$
$$= t_n (\tau_{n-1}-\tau_n) + \tau_n \qquad\qquad (3)$$

Wenn ein Nulldurchgang also in der Nähe des zweiten der beiden aufeinanderfolgenden Abtastwerte liegt, hat die vorhergehende Halbperiode also noch weit in diesen Abschnitt hineingereicht, und der Zwischenwert $\tau_z$ liegt daher auch in der Nähe des Wertes für die Dauer der vorhergehenden Halbperiode, und entsprechend umgekehrt. Diese Zwischenwerte sind in Fig. 3e) bereits an den entsprechenden Stellen mit einer durchgezogenen Linie eingezeichnet, während die unkorrigierten Werte in diesem Bereich gestrichelt gezeichnet sind. Die durchgezogene Linie der Fig. 3e) stellt also den korrigierten Verlauf der Werte $\tau_{vk}$ der Dauern der Halbperioden des Eingangssignals dar und bildet somit selbst in den Fällen, in denen nur wenige Abtastwerte in jeder Halbperiode liegen und die Dauern der Halbperioden sich schnell ändern, eine gute Annäherung an den tatsächlichen Verlauf der Dauern der Halbperioden.

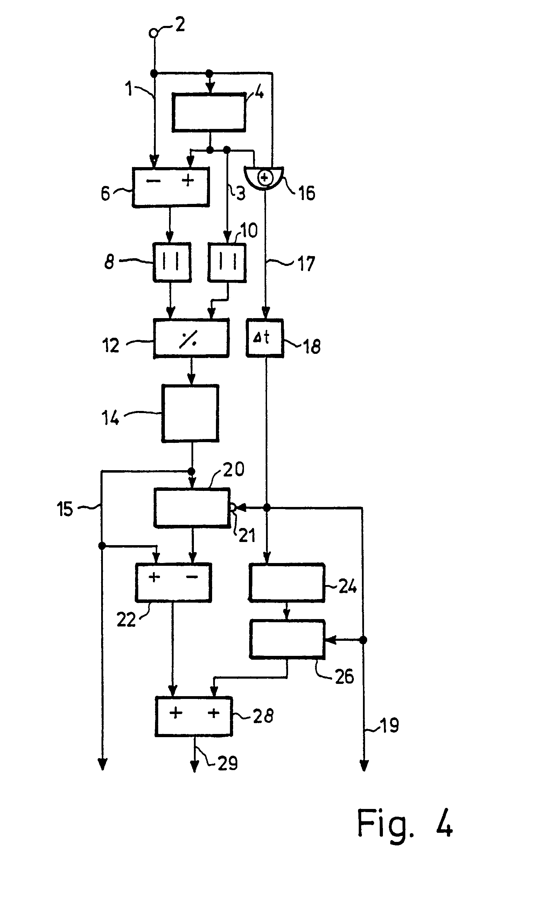

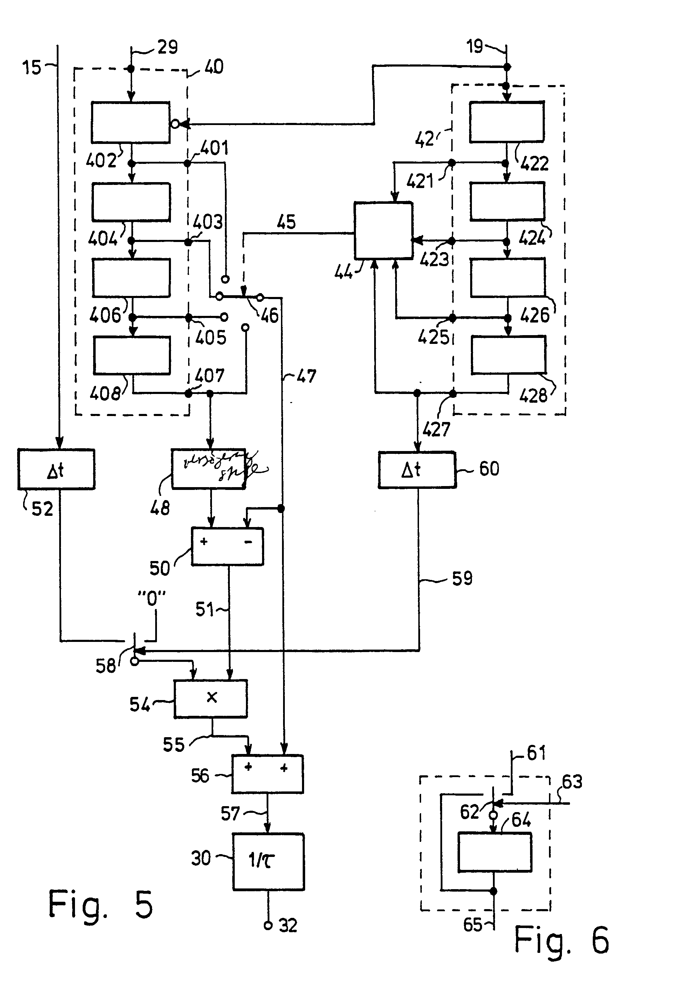

Nachstehend wird das Blockschaltbild einer Schaltungsanordnung beschrieben, die die auf die vorstehend beschriebene Weise ermittelten korrigierten Werte der Dauern der Halbperioden und daraus die Frequenz eines Eingangssignals ermittelt, wobei in Fig. 4 die Anordnung zur Erzeugung der Werte gemäß Fig. 3c) und Fig. 5 das Blockschaltbild einer Anordnung zur Erzeugung der in der Zeitdauer richtig zugeordneten und an den Übergängen korrigierten Werte zeigt.

Die dem zu demodulierenden Eingangssignal entsprechende Folge von Abtastwerten wird dem Eingang 2 der Anordnung in Fig. 4 zugeführt. Die Abtastwerte liegen beispielsweise als mehrstellige Dualwörter vor, bei denen die einzelnen Stellen parallel verarbeitet werden, so daß der Eingang 2 tatsächlich aus einer Anzahl paralleler Eingänge für die einzelnen Bits eines Datenwortes besteht, und entsprechend besteht die vom Eingang 2 weiterführende Verbindung 1 sowie die weiteren, in Fig. 4 und Fig. 5 dargestellten Leitungen aus einer Anzahl paralleler Leitungen entsprechend der Anzahl Bits jedes Datenwortes, mit Ausnahme der Leitungen, die das Nulldurchgangssignal bzw. davon abgeleitete Signale führen, wie unter anderem die Leitungen 17 und 19.

Der Eingang 2 führt über die Verbindung 1 auf ein Register 4, das mit jedem Taktsignal ein Datenwort speichert. Dieses Taktsignal, das nicht näher dargestellt ist und das insbesondere noch weiteren Registern zugeführt wird, is mit dem Zuführen der Abtastwerte zum Eingang 2 korreliert, d.h. jeweils mit dem Zuführen eines neuen Abtastwertes tritt auch ein Impuls des Taktsignals auf.

Die Verbindung 1 führt ferner auf einen Subtrahierer 6, dessen anderer Eingang mit dem Ausgang des Registers 4 verbunden ist und der die Differenz zwischen beiden Werten bildet. Der Ausgang der Subtrahierstufe 6 führt auf eine Betragbildungsstufe 8, die den Absolutbetrag der Differenz bildet, wobei beispielsweise bei Darstellung der Abtastwerte bzw. der daraus abgeleiteten Werte im Zweierkomplement eine gewisse Verarbeitung der zugeführten Werte erforderlich ist. In entsprechender Weise führt der Ausgang des Registers 4 über die Verbindung 3 ferner auf eine Betragbildungsstufe 10, die entsprechend aufgebaut ist. Wie aus Gleichung (2) ersichtlich, sind für die Zeitabschnitte $t_n$ nur positive Werte zulässig, und für eine einfache Realisierung der Division ist es zweckmäßig, nur die Beträge der Werte zu dividieren.

Diese Division erfolgt in der Dividierstufe 12, der die von den Stufen 8 und 10 gebildeten Beträge der Werte zugeführt werden. Die in Gleichung (2) angegebene Multiplikation mit der Dauer der Periode der Abtastwerte bzw. des Taktsignals kann weggelassen werden, da dieser Wert nur einen konstanten Skalierungsfaktor darstellt.

Die von der Dividierstufe 12 gebildeten Quotienten werden einer Korrekturschaltung 14 zugeführt, die aus einem Festwertspeicher besteht, dem die von der Dividierstufe 12 gebildeten Quotienten als Adressen zugeführt werden. An jeder Adresse, die einem bestimmten Wert des Zeitabschnittes $t_n$ entspricht, ist der um den Fehler F bei einer bestimmten mittleren Frequenz des Eingangssignals gemäß Fig. 1 und 2 korrigierte Zeitabschnitt enthalten, der über die Verbindung 15 ausgegeben wird.

Diese Verbindung 15 führt auf den Eingang eines weiteren Registers 20, das mit dem Ende eines Nulldurchgangssignals den Wert auf der Verbindung 15 einspeichert. Dieses in Fig. 3b) dargestellte Nulldurchgangssignal wird von einem Exklusiv-ODER-Verknüpfungsglied 16 erzeugt, das die Vorzeichenbits des dem Eingang 2 zugeführten und unverzögerten Abtastwertes und des vom Register 4 gelieferten verzögerten Abtastwertes erhält und auf der Leitung 17 ein Ausgangssignal erzeugt, wenn die beiden Vorzeichenbits unterschiedlich sind. Dieses Nulldurchgangssignal wird, wenn bei der Verarbeitung der Abtastwerte in den Stufen 6 bis 14 eine Verzögerung von mehr als einer Taktperiode auftritt, was insbesondere bei Ausführung der Dividierstufe 12 als Pipeline-Dividierer der Fall sein kann, einer Zeitverzögerungsstufe 18 zugeführt, die eine Verzögerungszeit aufwest, die gleich dieser Verzögerung ist. Das auf der Ausgangsleitung 19 erzeugte ggf. verozögerte Nulldurchgangssignal entspricht somit zeitlich dem am Eingang des Registers 20 anliegenden Datenwort. Dieses Register 20 enthält somit jeweils nach dem Ende des Nulldurchgangssignals, d.h. ohne Berücksichtigung einer Verzögerung nach dem zweiten Abtastwert nach einem Nulldurchgang, wie aus Fig. 3b) ersichtlich ist, einen der Dauer des Zeitabschnittes $t_n$ entsprechenden Wert.

Dieser Wert wird dem subtrahierenden Eingang einer Rechenstufe 22 zugeführt, deren anderer Eingang mit dem Ausgang der Korrekturschaltung 14 verbunden ist und beim nächsten Nulldurchgangssignal einen Wert entsprechend dem Zeitabstand $t_m$ gemäß Fig. 1 erhält.

Die das Nulldurchgangssignal führende Leitung 19 führt außerdem auf den Rücksetzeingang eines Zählers 24, der als Zähltakt das nicht dargestellte Taktsignal erhält. Der Ausgang des Zählers 24 ist mit einem Ausgangszählregister 26 verbunden, das den Zählerstand mit jedem Taktsignal und damit auch beim Auftreten eines Nulldurchgangssignals auf der Leitung 19 einschreibt. Das Ausgangszählregister 26 enthält somit bei jedem Nulldurchgangssignal einen Wert entsprechend der um "1" erhöhten Anzahl der Abtastwerte zwischen den unmittelbar vorhergehenden beiden Nulldurchgängen des Eingangssignals, wenn davon ausgegangen wird, daß der Zähler 24 mit dem Nulldurchgangssignal auf die Stellung "1" gesetzt wird und das Register 26 nur durch die Taktsignalflanke gesteuert den jeweils unmittelbar vor einem Taktsignal erreichten Zählerstand einschreibt. Es ist auch möglich, den Zähler 24 erst mit dem Ende des Nulldurchgangssignals in die Anfangsstellung "1" zu setzen, wodurch das Register 26 dann wegfällt oder die Ausgangsverbindung der Rechenstufe 22 sowie die Leitung 19 und die Verbindung 15 ebenfalls eine Verzögerung von einer Taktperiode eingefügt werden muß.

Die Ausgänge des Ausgangszählregisters 26 und der als Subtrahierer ausgebildeten Rechenstufe 22 sind mit den Eingängen eines Addierers 28 verbunden, der am Ausgang 29 also Werte entsprechend den Dauern jeder Halbperiode des dem Eingang 2 zugeführten Eingangssignals liefert, wobei diese Zeitdauern jedoch während einer nicht immer zutreffenden Zeit anstehen, wie in Fig. 3c) dargestellt ist. Außerdem ist bei der hier dargestellten Schaltung noch zu berücksichtigen, daß die Stufen 6 bis 14 und damit 22 und 28 nicht nur die Werte aus jeweils zwei aufeinanderfolgenden Abtastwerten beiderseits eines Nulldurchganges verarbeiten, sondern auch alle übrigen Abtastwerte, so daß am Ausgang 29 zwischen jeweils zwei richtigen Werten, die die Dauer der letzten Halbperiode angeben, jeweils falsche bzw. sinnlose Werte ausgegeben werden. Dies wird jedoch bei der Weiterverarbeitung dieser Werte in der Anordnung nach Fig. 5 berücksichtigt, die auch die zeitlich richtigen Dauern der Werte gemäß Fig. 3e) bildet.

Die auf der Verbindung 29 auftretenden Werte werden in Fig. 5 einer Verzögerungskette 40 zugeführt, die als Schieberegister aus den in Reihe geschalteten Registerstufen 402, 404, 406 und 408 ausgebildet ist. Die Registerstufe 402 übernimmt jeweils nur am Ende eines Nulldurchgangssignals auf der Leitung 19 den auf der Verbindung 29 anliegenden Wert, während die anderen Registerstufen 404, 406 und 408 mit jedem Taktsignal den am Eingang anliegenden Wert übernehmen. Dadurch sind allgemein in mehreren aufeinanderfolgenden Stufen die gleichen Werte enthalten, was für die Bildung der Folge der Werte mit den richtigen Zeitdauern gemäß Fig. 3d) erforderlich ist. Die Abgriffe 401, 403, 405 und 407 der Verzögerungskette, die mit den Ausgängen der Stufen 402, 404, 406 und 408 verbunden sind, sind mit den einzelnen Stellungsanschlüssen eines Umschalters 46 verbunden, der zweckmäßig als elektronischer Multiplexer ausgeführt ist.

Das Nulldurchgangssignal auf der Leitung 19 wird einer der Verzögerungskette 40 entsprechenden Verzögerungskette 42 zugeführt, die ebenfalls eine Anzahl in Reihe geschalteter Stufen 422, 424, 426 und 428 aufweist, die von dem Taktsignal gesteuert werden. Jede dieser Stufen enthält jedoch nur ein Bit im Gegensatz zu den Stufen 402 bis 408 der Verzögerungskette 40, die jeweils ein Datenwort enthalten. Die Abgriffe 421, 423, 425 und 427 der Verzögerungskette 42 sind mit den Ausgängen der entsprechenden Stufen 422 bis 428 verbunden und entsprechen damit den Abgriffen der Verzögerungskette 42.

Die Abgriffe 421 bis 427 der Verzögerungskette 42 sind mit den Eingängen einer Auswerteschaltung 44 verbunden, die als Festwertspeicher ausgeführt ist, wobei die Eingänge die Adresseneingänge des Festwertspeichers darstellen. Jede Adresse des Festwertspeichers ist damit einer bestimmten Kombination von Signalen an den Abgriffen 421 bis 427, d.h. einem bestimmten Muster des Nulldurchgangssignals auf der Leitung 19, zugeordnet und enthält eine Bitkombination, die auf der Leitung 45 ausgegeben wird und den Umschalter 46 in eine eindeutige Stellung schaltet. Da der Umschalter 46 in dem dargestellten Ausführungsbeispiel vier Stellungen aufweist, genügen zwei Bit an jeder Adresse des Festwertspeichers in der Auswahlschaltung 44, so daß die Leitung 45 tatsächlich aus zwei Leitungen besteht. Der Inhalt des Festwertspeichers bei den verschiedenen Signalkombinationen an den Abgriffen 421 bis 427 ist in der Tabelle dargestellt:

T A B E L L E

| 421 | 423 | 425 | 427 | 45 |
|-----|-----|-----|-----|----|
| 0 | 0 | 0 | 0 | * |
| 0 | 0 | 0 | 1 | 3 |
| 0 | 0 | 1 | 0 | 2 |
| 0 | 0 | 1 | 1 | 3 |
| 0 | 1 | 0 | 0 | 1 |
| 0 | 1 | 0 | 1 | 3 |
| 0 | 1 | 1 | 0 | 2 |
| 0 | 1 | 1 | 1 | 3 |
| 1 | 0 | 0 | 0 | 0 |
| 1 | 0 | 0 | 1 | 3 |
| 1 | 0 | 1 | 0 | 2 |
| 1 | 0 | 1 | 1 | 3 |
| 1 | 1 | 0 | 0 | 1 |
| 1 | 1 | 0 | 1 | 3 |
| 1 | 1 | 1 | 0 | 2 |
| 1 | 1 | 1 | 1 | 3 |

Darin bedeutet der Wert "0" auf der Leitung 45, daß der Umschalter 46 mit dem Ausgang 401 verbunden ist, und die übrigen Werte sin den Anderen Ausgängen in der gleichen Reihenfolge zugeordnet. Die Bitkombination, die den Wert * ergibt, kann bei den hier vorkommenden Frequenzen des zu demodulierenden Signals nicht auftreten bzw. bedeutet eine so niedrige Frequenz im Verhältnis zur Frequenz des Taktsignals, daß dafür die Länge der Verzögerungsketten 40 und 42 vergrößert werden müßten.

Durch die Steuerung des Umschalters 46 gemäß dieser Tabelle ensteht auf der Verbindung 47 vom Ausgang des Umschalters 46 die Folge der Werte für die Dauern aufeinanderfolgender Halbperioden mit der jeweils richtigen Zeitdauer gemäß der Fig. 3d).

Die Bildung der Zwischenwerte gemäß Fig. 3e) erfolgt mit den weiteren in Fig. 5 dargestellten Elementen. Von diesen ist der Eingang eines Registers 48 mit dem Abgriff 407 der Verzögerungskette 40 verbunden, und das Register 48 schreibt mit jedem Taktsignal den an dem diesem Abgriff vorhanden Wert ein. Dies ist der Wert der Periodendauer, für die das zugehörige Nulldurchgangssignal gleichzeitig am Ausgang 427 der Verzögerungskette 42 erscheint. Wenn dieser Wert in das Register 48 eingeschrieben ist, liegt auf der Verbindung 47 durch entsprechende Einstellung des Umschalters 46 gleichzeitig der Wert der folgenden Periodendauer. Der Ausgang des Registers 48 ist mit dem addierenden Eingang eines Subtrahierers 50 verbunden, dessen subtrahierender Eingang mit der Verbindung 47 verbunden ist, so daß auf der Ausgangsverbindung 51 zumindest zu einem Zeitpunkt entsprechend der durch das Register 48 verursachten Verzögerung die Differenz der Werte der Dauern zweier aufeinanderfolgender Halbperioden vorhanden sind. Das entsprechend verzögerte Nulldurchgangssignal wird dem Ausgang 59 einer Verzögerungsstufe 60 entnommen, das mit dem Abgriff bzw. Ausgang 427 der Verzögerungskette 42 verbunden ist, und es betätigt einen Umschalter, dessen Funktion nachfolgend näher erläutert wird.

Die Verbindung 51 ist mit dem einen Eingang eines Multiplizierers 54 verbunden, dessen anderer Eingang auf den Umschalter 58 führt. Dieser Umschalter 58 führt bei fehlendem Nulldurchgangssignal den Wert "0" dem Multiplizierer 54 zu, so daß auf dessen Ausgangsverbindung 55 ebenfalls der Wert "0" erscheint. Bei einem Nulldurchgangssignal verbindet der Umschalter 58 den betreffenden Eingang des Multiplizierers 54 mit dem Ausgang einer Verzögerungsschaltung 52, die eine Verzögerung gleich der Summe der Verzögerungen des Registers 48 und der Verzögerungskette 40 aufweist und beispielsweise ebenfalls als Schieberegister mit einer entsprechenden Anzahl Stufen aufgebaut sein kann. Der Eingang der Verzögerungsschaltung 52 ist mit der Verbindung 15 verbunden, die den Wert des Zeitabschnittes $t_m$ führt, der infolge der Verzögerung durch die Verzögerungsschaltung 52 zu dem jeweils gleichzeitig auf der Verbindung 47 vorhandenen Wert der Dauer einer Halbperiode gehört.

Dieser Wert wird dem einen Eingang eines Addierers 56 zugeführt, dessen anderer Eingang mit der Verbindung 55 vom Multiplizierer 54 verbunden ist. Auf dessen Ausgangsverbindung 57 wird somit beim Übergang von dem Wert der Dauer jeweils einer Halbperiode zu dem der nächsten Halbperiode ein zwischen diesen beiden Werten liegender Zwischenwert erzeugt. Die auf der Ausgangsverbindung 57 somit erzeugten korrigierten Werte der Dauern der einzelnen Halbperioden werden dem Eingang des Kehrwertbildners 30 zugeführt, der zweckmäßig als Festwertspeicher realisiert ist, dessen Adressenleitungen mit dem Eingang des Kehrwertbildners 30 verbunden sind und der die an den Adressen vorhandenen Daten am Ausgang 32 der Anordnung abgibt. Diese am Ausgang 32 erscheinenden Werte stellen die Folge der Momentanfrequenzen des Eingangssignals entsprechend den dem Eingang 2 zugeführten Abtastwerten dar, allerdings mit einer konstanten Zeitverzögerung, die bei dem hier dargestellten Beispiel vor allem die Verzögerungkette 40 erzeugt wird. Die Zeitverzögerung der Verzögerungskette 40 und damit die der Verzögerungskette 42 hängt ab von der Dauer der längsten im Eingangssignal vorkommenden Halbperiode, streng genommen von dem Unterschied zwischen der kleinsten und der größten Dauer der tatsächlich auftretenden Halbperioden des Eingangssignals. Die zeitliche Verschiebung zwischen dem Eingangssignal und den dessen Momentanfrequenz angebenden Ausgangssignalen am Ausgang 32 kann noch größer werden, wenn insbesondere den einzelnen Rechenstufen noch Verzögerungsstufen nachgeschaltet werden, wobei darauf zu achten ist, daß in sämtlichen parallelen Signalwegen die Anzahl der Verzögerungen bzw. Verzögerungsstufen gleich ist, um die Laufzeit der Signale in den einzelnen Rechenstufen auszugleichen, so daß diese Laufzeit nahezu gleich der Periode des Taktsignals sein kann. Derartige zusätzliche Verzögerungsstufen sind in dem vorliegenden Ausführungsbeispiel jedoch der Übersichtlichkeit halber weggelassen.

Die in dem beschriebenen Ausführungsbeispiel dargestellten und gegebenenfalls noch zusätzlich verwendeten Registerstufen bzw. Verzögerungsstufen werden zweckmäßig als Auffangregister ausgeführt, die alle mit dem Taktsignal betrieben werden, d.h. mit jedem Impuls des Taktsignals den Eingangswert übernehmen und an den Ausgang weiterleiten. Dies ist besonders günstig, wenn die gesamte Schaltungsanordnung als integrierte Schaltung in sogenannter dynamischer MOS-Technik ausgeführt wird. Damit auch die Registerstufen bzw. Verzögerungsstufen, die nur mit einem Nulldurchgangssignal einen Wert übernehmen sollen, in entsprechender Weise aufgebaut werden können, ist es zweckmäßig, diese gemäß Fig. 6 auszuführen. Dabei ist ein Auffangregister 64 vorgesehen, das mit dem allgemeinen Taktsignal betrieben wird. Dem Eingang dieses Auffangregisters 64 ist jedoch ein Umschalter 62 vorgeschaltet, der über die Leitung 63 vom Nulldurchgangssignal gesteuert den Eingang 61 der Stufe mit dem Eingang des Auffangregisters 64 verbindet. Bei fehlendem Nulldurchgangssignal auf der Leitung 63 ist der Eingang des Auffangregisters 64 mit dessen Ausgang 65 verbunden, so daß sein einmal eingeschriebener Inhalt bei den nächsten Taktsignalen nicht verändert wird.

**Patentansprüche**

1. Verfahren zum Demodulieren eines frequenzmodulierten, periodischen Eingangssignals durch Bestimmung der Dauer jeder Halbperiode zwischen jeweils zwei benachbarten Nulldurchgängen des Eingangssignals, das als Folge von in gleichen Abständen aus dem Eingangssignal gewonnenen digitalisieten Abtastwerten vorliegt, wobei die Dauer $\tau$ jeder Halbperiode aus der Summe der Zeitabstände T entsprechend der Anzahl n von ganzen Perioden der Abtastwerte zwischen den benachbarten Nulldurchgängen und den Zeitabstäden $t_n$, $t_m$ zwischen jedem Nulldurchgang und dem diesem unmittelbar vorhergehenden Abtastwert aus folgender Beziehung abgeleitet wird:

$$\tau = (T - t_n) + nT + t_m$$
$$= t_m - t_n + (N+1)T,$$

und wobei die Zeitabstände $t_n$ und $t_m$ je aus zwei aufeinanderfolgenden Abtastwerten $a_n$, $a_{n+1}$ bzw. $a_m$, $a_{m+1}$ unterschiedlichen Vorzeichens im Bereich der Nulldurchgänge aus folgender Beziehung abgeleitet werden:

$$t_n = T \frac{|a_{n-1}|}{|a_{n-1} - a_n|}$$

$$t_m = T \frac{|a_{m-1}|}{|a_{m-1} - a_m|}$$

dadurch gekennzeichnet, daß die Kehrwerte der Dauern τ der Halbperioden gebildet werden und die ermittelte Dauer τ jeder Halbperiode einen Zeitabschnitt gleich dem Abstand einer Anzahl Abtastwerte aufrechterhalten wird, die um 1 größer als die Anzahl der Abtastwerte zwischen dem ersten der beiden benachbarten Nulldurchgänge und dem vorhergehenden Nulldurchgang ist.

2. Verfahren nach Anspruch 1, dadurch gekennzeichnet, daß jeder Zeitabstand $t_n$, $t_m$ vor der Bestimmung der Dauer der Halbperiode um einen vom Wert dieses Zeitabstandes abhängigen Korrekturwert korrigiert wird.

3. Verfahren nach Anspruch 1, dadurch gekennzeichnet, daß dem Zeitabschnitt zwischen den aufeinanderfolgenden Abtastwerten $a_n$, $a_{n+1}$ im Bereich des ersten der beiden Nulldurchgänge eine Periodendauer $\tau_{vk}$ zugeordnet wird, die abhängig von dem ermittelten und gegebenenfalls korrigierten Zeitabschnitt $t_n$ zwischen diesem Nulldurchgang und dem vorhergehenden Abtastwert zwischen der vor diesem Nulldurchgang ermittelten Periodendauer $\tau_{n-1}$ und der zuletzt ermittelten Periodendauer $\tau_n$ gemäß folgender Beziehung liegt:

$$\tau_{vk} = t_n (\tau_{n-1} - \tau_n) + \tau_n.$$

4. Anordnung zur Durchführung des Verfahrens nach Anspruch 1, mit einem Eingang, dem die digitalen Abtastwerte im Takte eines Taktsignals nacheinander zugeführt werden, und einem Ausgang, der im gleichen Takte Ausgangswörter abgibt, die die momentane Frequenz des durch die zugeführten Abtastwerte dargestellten Eingangssignals angeben, gekennzeichnet durch

eine erste Verzögerungsstufe (4), die jeden dem Eingang (2) zugeführten digitalen Abtastwert um eine Periode des Taktsignals verzögert,

eine Exklusiv-ODER-Verknüpfungsschaltung (16), die das Vorzeichensignal jedes dem Eingang (2) der Anordnung zugeführten und jedes verzögerten Abtastwertes erhält und ein Nulldurchgangssignal erzeugt, wenn die beiden Vorzeichensignale unterschiedlich sind,

eine erste Rechenstufe (6), die mit dem Eingang (2) der Anordnung und dem Ausgang der ersten Vorzögerungsstufe (4) gekoppelt ist und den Unterschied zweier aufeinanderfolgender Abtastwerte liefert,

eine Dividierstufe (12), deren Eingänge mit dem Ausgang der ersten Rechenstufe (6) und dem Ausgang der Verzögerungsstufe (4) gekoppelt sind und die den Quotienten aus den Beträgen der von diesen Stufen abgegebenen Werte bildet,

eine zweite Verzögerungsstufe (20), deren Eingang mit dem Ausgang der Dividierstufe (12) gekoppelt ist und die von dem Nulldurchgangssignal gesteuert deren aus den Abtastwerten unterschiedlichen Vorzeichens gebildeten Quotienten jeweils vor dem Auftreten eines neuen Quotienten einspeichert,

einen Zähler (24) mit Ausgangszählregister (26), der das Taktsignal als Zählsignal erhält und beim Nulldurchgangssignal den Zählerstand in das Ausgangszählregister (26) einschreibt und auf eine Anfangsstellung zurückschaltet,

eine zweite Rechenstufe (22, 28), von der ein erster Eingang mit dem Ausgang der Dividierstufe (12), ein zweiter Eingang mit dem Ausgang der zweiten Verzögerungsstufe (20) und ein dritter Eingang mit dem Ausgang des Ausgangszählregisters (26) gekoppelt ist und die die Differenz zwischen dem den zweiten Eingang zugeführten Wert und der Summe der dem ersten und dem dritten Eingang zugeführten Werte bildet, und

einen Kehrwertbildner (30), dessen Eingang mit dem Ausgang der zweiten Rechenstufe (22, 28) gekoppelt und dessen Ausgang mit dem Ausgang (32) der Anordnung verbunden ist.

5. Anordnung nach Anspruch 4 zur Durchführung des Verfahrens nach Anspruch 2, dadurch gekennzeichnet, daß der Dividierstufe (12) eine Korrekturschaltung (14) nachgeschaltet ist, die jeden von der Dividierstufe (12) gelieferten Quotienten um einen mindestens von diesem Quotienten abhängigen Korrekturwert korrigiert.

6. Anordnung nach Anspruch 5, dadurch gekennzeichnet, daß die Korrekturschaltung (14) ein Festwertspeicher ist, dessen Adresseneingänge mindestens mit dem Ausgang der Dividierstufe (12) und dessen Datenausgänge mit dem Eingang der zweiten Verzögerungsstufe (20) und dem einen Eingang der zweiten Rechenstufe (22, 28) gekoppelt sind.

7. Anordnung nach Anspruch 4 zur Durchführung des Verfahrens nach Anspruch 1, dadurch gekennzeichnet,

daß eine erste Verzögerungskette (40) zum Verzögern mehrerer Datenworte mit einer Anzahl Abgriffen (401, . . . 407) vorgesehen ist, deren Eingang mit dem Ausgang der zweiten Recheneinheit (22, 28) gekoppelt ist und die mit jedem Nulldurchgangssignal ein Datenwort übernimmt und deren Abgriffe (401, . . . 407) mit den Eingängen eines Umschalters (46) mit mehreren Stellungen verbunden sind,

daß eine zweite Verzögerungskette (42) mit der ersten Verzögerungskette (40) entsprechenden Abgriffen (421, . . . 427) vorgesehen ist, die das Nulldurchgangssignal empfängt und an deren Abgriffen (421, . . . 427) eine Auswerteschaltung (44) angeschlossen ist, die abhängig von der Kombination der Signale an den Abgriffen (421, . . . 427) ein Steuersignal erzeugt, das den Umschalter (46) auf eine der Kombination zugeordnete Stellung einstellt, und

daß der Eingang des Kehrwertbildners (30) mit dem Ausgang des Umschalters (46) gekoppelt ist.

8. Anordnung nach Anspruch 7, dadurch gekennzeichnet, daß die erste und die zweite Verzögerungskette (40, 42) als Schieberegister mit einer Anzahl vom Taktsignal gesteuerten Stufen (402, . . . 408; 422, . . .

**EP 0 099 142 B1**

428) aufgebaut ist, wobei in der ersten Vorzögerungskette (40) jede Stufe ein Datenwort speichert, und daß die Abgriffe (401, . . . 407; 421, . . . 427) die Ausgänge der einzelnen Stufen (402, . . . 408; 422, . . . 426) bzw. der Eingang der zweiten Verzögerungskette (42) sind.

9. Anordnung nach Anspruch 7 oder 8 zur Durchführung des Verfahrens nach Anspruch 3, dadurch gekennzeichnet, daß der Ausgang des Umschalters (46) mit dem einen Eingang einer dritten Recheneinheit (50) verbunden ist, von der ein anderer Eingang über eine dritte Verzögerungsstufe (48), die jedes zugefürte Datenwort um eine Periode des Taktsignals verzögert, mit dem letzten Abgriff (407) der ersten Verzögerungskette (40) gekoppelt ist und die die Differenz der den beiden Eingängen zugeführten Werte am Ausgang abgibt, daß der Ausgang der dritten Rechenstufe (50) mit einem ersten Eingang einer vierten Rechenstufe (54, 56) gekoppelt ist, von der ein zweiter Eingang über eine vierte Verzögerungsstufe (52) mit einer Verzögerungszeit gleich der Summe der Verzögerungszeit der ersten bzw. zweiten Verzögerungskette (40, 42) und der dritten Verzögerungsstufe (48) mit dem Ausgang der Dividierstufe (12) bzw. der dieser nachgeschal- teten Korrekturschaltung (14) und von der ein dritter Eingang mit dem Ausgang des Umschalters (46) gekoppelt ist und die vom um die Verzögerungszeit der ersten bzw. zweiten Verzögerungskette (40, 42) verzögerten Nulldurchgangssignal gesteuert in der Taktperiode vor dem Zuführen eines neuen Wertes zum Ausgang des Umschalters (46) das Produkt des dem ersten und dem zweiten Eingang der vierten Rechenstufe (54, 56) zugeführten Werte und in den übrigen Taktperioden den Wert "0" zu dem Ausgangssignal der Umschalters (46) addiert und die Summe dem Kehrwertbildner (30) zuführt.

10. Anordnung nach Anspruch 9, dadurch gekennzeichnet, daß mindestens ein dem ersten oder dem zweiten Eingang der vierten Rechenstufe (54, 56) vorgeschalteter, vom Nulldurchgangssignal gesteuerter Umschalter (58) vorgesehen ist, der bei fehlendem Nulldurchgangssignal dem betreffenden Eingang ein Datenwort mit dem Wert "0" zuführt.

11. Anordnung nach Anspruch 4 oder einem der folgenden, dadurch gekennzeichnet, daß der Kehrwertbildner (30) ein Festwertspeicher ist, dessen Adresseneingang mit dem Ausgang der zweiten (22, 28) bzw. der vierten Rechenstufe (54, 56) und dessen Datenausgang mit dem Ausgang (32) der Anordnung verbunden ist.

12. Anordnung nach Anspruch 4 oder einem der folgenden, dadurch gekennzeichnet, daß die zweite Verzögerungsstufe (20) und/oder die erste Stufe (402) der ersten Verzögerungskette (40) zum Einspeichern von nur solchen Werten, die mit dem Nulldurchgangssignal auftreten, aus einer vom Taktsignal gesteuerten Registerstufe (64) mit einem vom Nulldurchgangssignal gesteuerten zweiten Umschalter (62) bestehen, der bei fehlendem Nulldurchgangssignal den Ausgang der Registerstufe (64) mit deren Eingang verbindet.

**Revendications**

1. Procédé de démodulation d'un signal périodique d'entrée modulé en fréquence, par la détermination de la durée de chaque demi-période entre chaque fois deux passages par zéro voisins du signal d'entrée, qui est présente en tant que succession de valeurs d'échantillonnage numérisées obtenues à intervalles égaux à partir du signal d'entrée, la durée $\tau$ de chaque demi-période étant dérivée de la somme des intervalles temporels T selon le nombre n de périodes entières de valeurs d'échantillonnage entre les passages par zéro voisins et des intervalles temporels $t_n$, $t_m$ entre chaque passage par zéro et la valeur d'échantillonnage immédiatement précédente, par application de l'équation suivante:

$$\tau = (T - t_n) + nT + t_m$$
$$= t_m - t_n + (n+1)T$$

et les intervalles temporels $t_n$ et $t_m$ étant dérivés chacun de deux valeurs d'échantillonnage successives $a_n$, $a_{n+1}$ et $a_m$, $a_{m+1}$ de signes différents dans le domaine des passages par zéro, par application de l'équation suivante:

$$t_n = T \frac{a_{n-1}}{a_{n-1} - a_n}$$

$$t_m = T \frac{a_{m-1}}{a_{m-1} - a_m}$$

caractérisé en ce que les valeurs inverses des durées $\tau$ des demi-périodes sont formées et la durée $\tau$ de chaque demi-période déterminée est maintenue pendant un intervalle temporel égal à l'intervalle couvert par un nombre de valeurs d'échantillonnage qui est supérieur d'une unité au nombre de valeurs d'échantillonnage entre le premier des deux passages par zéro voisins et le passage par zéro précédent.

11

2. Procédé suivant la revendication 1, caractérisé en ce que chaque intervalle temporel $t_n$, $t_m$ est corrigé avant la détermination de la durée de la demi-période d'une valeur de correction dépendant de la valeur de cet intervalle temporel.

3. Procédé suivant la revendication 1, caractérisé en ce qu'à l'intervalle temporel entre les valeurs d'échantillonnage successives $a_n$, $a_{n+1}$ dans le domaine du premier des deux passages par zéro, est attribuée une durée de période $\tau_{vk}$ qui, en fonction de l'intervalle temporel $t_n$ déterminé et, le cas échéant, corrigé, entre ce passage par zéro et la valeur d'échantillonnage précédente, se situe entre la durée de période $\tau_{n-1}$ déterminée avant ce passage par zéro et la durée de période $\tau_n$ déterminée en dernier lieu, conformément à l'équation suivante:

$$\tau_{vk} = t_n \, (\tau_{n-1} - \tau_n) + \tau_n$$

4. Montage pour l'exécution du procédé suivant la revendication 1, comportant une entrée à laquelle les valeurs d'échantillonnage numériques sont appliquées successivement au rythme d'un signal d'horloge, et une sortie, qui, à la même cadence, fournit des mots de sortie qui indiquent la fréquence instantanée du signal d'entrée représenté par les valeurs d'échantillonnage appliquées, caractérisé par

un premier étage de retardement (4) qui retarde chaque valeur d'échantillonnage numérique appliquée à l'entrée (2) d'une période du signal d'horloge,

un circuit logique OU exclusif (16), qui reçoit le signal de signe de chaque valeur d'échantillonnage appliquée à l'entrée (2) du montage et de chaque valeur d'échantillon retardée et produit un signal de passage par zéro lorsque les deux signaux de signes sont différents,

un premier étage de calcul (6), qui est couplé à l'entrée (2) du montage et à la sortie du premier étage de retardement (4) et qui fournit la différence de deux valeurs d'échantillonnage successives,

un étage diviseur (12), dont les entrées sont couplées à la sortie du premier étage de calcul (6) et à la sortie de l'étage de retardement (4) et qui forme le quotient des valeurs absolues des valeurs fournies par ces étages,

un second étage de retardement (20), dont l'entrée est couplée à la sortie de l'étage diviseur (12) et qui, sous la commande du signal de passage par zéro, stocke le quotient formé des valeurs d'échantillonnage de signes différents, chaque fois avant l'apparition d'un nouveau quotient,

un compteur (24) avec un registre de comptage de sortie (26), qui reçoit le signal d'horloge en tant que signal de comptage et, lors du signal de passage par zéro, inscrit l'état de comptage dans le registre de comptage de sortie (26) et revient à une position initiale,

un second étage de calcul (22, 28), dont une première entrée est couplée à la sortie de l'étage diviseur (12), une deuxième entrée est couplée à la sortie du second étage de retardement (20) et une troisième entrée est couplée à la sortie du registre de comptage de sortie (26) et qui forme la différence entre la valeur appliquée à la seconde entrée et la somme des valeurs appliquées à la première et à la troisième entrée, et

un formateur de valeur inverse (30), dont l'entrée est couplée à la sortie du second étage de calcul (22, 28) et dont la sortie est connectée à la sortie (32) du montage.

5. Montage suivant la revendication 4 pour l'exécution du procédé suivant la revendication 2, caractérisé en ce que l'étage diviseur (12) est suivi d'un circuit de correction (14) qui corrige chaque quotient fourni par l'étage diviseur (12) d'une valeur de correction dépendant au moins de ce quotient.

6. Montage suivant la revendication 5, caractérisé en ce que le circuit de correction (14) est une mémoire fixe, dont les entrées d'adresses sont couplées au moins à la sortie de l'étage diviseur (12) et dont les sorties de données sont couplées à l'entrée du second étage de retardement (20) et à l'une des entrées du second étage de calcul (22, 28).

7. Montage suivant la revendication 4 pour l'exécution du procédé conforme à la revendication 1, caractérisé en ce

qu'est prévue une première ligne à retard (40) pour retarder plusieurs mots de données, présentant un certain nombre de prises (401, . . . , 407), dont l'entrée est couplée à la sortie de la seconde unité de calcul (22, 28) et reprend un mot de données à chaque signal de passage par zéro et dont les prises (401, . . . , 407) sont connectées aux entrées d'un commutateur (46) à plusieurs positions,

qu'est prévue une seconde ligne à retard (42) présentant des prises (421, . . . , 427) correspondant à celles de la première ligne à retard (40), qui reçoit le signal de passage par zéro et aux prises (421, . . . , 427) de laquelle est connecté un circuit d'évaluation (44), qui, en fonction de la combinaison des signaux sur les prises (421, . . . , 427), produit un signal de commande qui règle le commutateur (46) sur une position associée à la combinaison, et

que l'entrée du formateur de valeur inverse (30) est couplée à la sortie du commutateur (46).

8. Montage suivant la revendication 7, caractérisé en ce que la première et la seconde ligne à retard (40, 42) ont la forme d'un registre à décalage comportant un certain nombre d'étages (402, . . . , 408; 422, . . . , 428) commandés par le signal d'horloge, chaque étage de la première ligne à retard (40) stockant un mot de données et que les prises (401, . . . , 407; 421, . . . , 427) sont les sorties des divers étages (402, . . . , 408; 422, . . . , 426) ou l'entrée de la seconde ligne à retard (42).

9. Montage suivant la revendication 7 ou 8 pour l'exécution du procédé suivant la revendication 3, caractérisé en ce que la sortie du commutateur (46) est connectée à l'une des entrées d'une troisième unité de calcul (50), dont une autre entrée est couplée, par l'intermédiaire d'un troisième étage de retardement (48), qui retarde chaque mot de données appliqué d'une période du signal d'horloge, à la dernière prise (407) de la première ligne à retard (40) et qui fournit à sa sortie la différence des valeurs appliquées aux deux entrées, que la sortie du troisième étage de calcul (50) est couplée à une première entrée d'un quatrième étage de calcul (54, 56), dont une seconde entrée est couplée, par l'intermédiaire d'un quatrième étage de retardement (52) présentant un temps de retardement égal à la somme des temps de retardement de la première ou de la seconde ligne à retard (40, 42) et du troisième étage de retardement (48), à la sortie de l'étage diviseur (12) ou au circuit de correction (14) qui est disposé en aval de celui-ci et dont une troisième entrée est couplée à la sortie du commutateur (46) et qui, sous la commande du signal de passage par zéro retardé du temps de retardement de la première ou de la seconde ligne à retard (40, 42), effectue, dans la période d'horloge précédant l'application d'une nouvelle valeur à la sortie du commutateur (46), l'addition du produit des valeurs appliquées à la première et à la deuxième entrée du quatrième étage de calcul (54, 56) et dans les autres périodes d'horloge, la valeur "0", au signal de sortie du commutateur (46) et applique la somme au formateur de valeur inverse (30).

10. Montage suivant la revendication 9, caractérisé en ce qu'est prévue au moins un commutateur (58) commandé par le signal de passage par zéro et disposé en avant de la première ou de la deuxième entrée du quatrième étage de calcul (54, 56), qui, en l'absence de signal de passage par zéro, applique à l'entrée en question un mot de données de la valeur "0".

11. Montage suivant la revendication 4 ou l'une quelconque des revendications suivantes, caractérisé en ce que le formateur de valeur inverse (30) est une mémoire non volatile, dont l'entrée d'adresses est connectée à la sortie du deuxième (22, 28) ou du quatrième étage de calcul (54, 56) et dont la sortie de données est connectée à la sortie (32) du montage.

12. Montage suivant la revendication 4 ou l'une quelconque des revendications suivantes, caractérisé en ce que le deuxième étage de retardement (20) et/ou le premier étage (402) de la première ligne à retard (40), aux fins de ne stocker que des valeurs qui apparaissent au signal de passage par zéro, sont constitués d'un étage de registre (64) commandé par le signal d'horloge comportant un second commutateur (62) commandé par le signal de passage par zéro qui, en l'absence de signal de passage par zéro, connecte la sortie de l'étage de registre (64) à son entrée.

## Claims

1. A method of demodulating a frequency-modulated periodic input signal by determining the duration of each half-cycle between every two adjacent zero crossings of the input signal, which signal is available as a series of digitized samples derived from the input signal at equal intervals, the duration $\tau$ of each half-cycle being derived from the sum of the time intervals T corresponding to the number $n$ of whole periods of the samples between the adjacent zero crossings and the time intervals $t_n$, $t_m$ between each zero crossing and the sample directly preceding it, using the following relationship:

$$\tau = (T - t_n) + nT + t_m$$
$$= t_m - t_n + (n + 1)T,$$

the time intervals $t_n$ and $t_m$ each being respectively derived from two consecutive samples $a_n$, $a_{n+1}$ and $a_m$, $a_{m+1}$ having different signs at the location of the zero crossings by means of the following relationship:

$$t_n = T \frac{|a_{n-1}|}{|a_{n-1} - a_n|}$$

$$t_m = T \frac{|a_{m-1}|}{|a_{m-1} - a_m|}$$

characterized in that the reciprocals of the duration $\tau$ of the half-cycles are generated and the duration $\tau$ determined for each half-cycle is maintained for a time interval equal to the interval between a number of samples which is 1 higher than the number of samples between the first of the two adjacent zero crossings and the preceding zero crossing.

2. A method as claimed in Claim 1, characterized in that prior to the determination of the half-cycle duration each time interval $t_n$, $t_m$ is corrected by a correction value which depends on the value of said time interval.

3. A method as claimed in Claim 1, characterized in that a period $\tau_{vk}$ is assigned to the time interval between the consecutive samples $a_n$, $a_{n+1}$ at the location of the first one of the two zero crossings, which period, depending upon the determined and, if applicable, corrected time interval $t_n$ between said zero crossing and the preceding sample, is situated between the period $\tau_{n+1}$ determined before said zero

# EP 0 099 142 B1

crossing and the last determined period $\tau_n$ in conformity with the following relationship:

$$\tau_{vk} = t_n (\tau_{n-1} - \tau_n) + \tau_n.$$

4. An arrangement for carrying out the method as claimed in Claim 1, which arrangement comprises an input to which the digital samples are applied consecutively in the rhythm of a clock signal and an output which supplies output words in the same rhythm, which output words are representative of the instantaneous frequency of the input signal represented by the applied samples, characterized by

a first delay stage (4), which delays each digital sample applied to the input (2) by one period of the clock signal,

an exclusive-OR logic circuit (16), which receives the sign signal of each sample applied to the input (2) of the arrangement and subsequently delayed and which generates a zero-crossing signal if the two sign signals are different,

a first arithmetic stage (6), which is coupled to the input (2) of the arrangement and to the output of the first delay stage (4) and which supplies the difference between two consecutive samples,

a divider stage (12), which has its inputs coupled to the output of the first arithmetic stage (6) and to the output of the delay stage (4) and which forms the quotients of the values supplied by said stages,

a second delay stage (20), which has its input coupled to the output of the divider stage (12) and which under control of the zero-crossing signal stores the quotients of the samples of different signs before a new quotient appears,

a counter (24) having an output count register (26), which counter receives the clock signal as counting signal and in response to the zero-crossing signal loads the count into the output count register (26) and is reset to an initial count,

a second arithmetic stage (22, 28), having a first input coupled to the output of the divider stage (12), having a second input coupled to the output of the second delay stage (20) and having a third input coupled to the output of the output count register (26) to form the difference between the value applied to the second input and the sum of the values applied to the first and the third input, and

a reciprocal-value generator (30), having its input coupled to the output of the second arithmetic stage (22, 28) and having its output connected to the output (32) of the arrangement.

5. An arrangement as claimed in Claim 4, for carrying out the method as claimed in Claim 2, characterized in that the divider stage (12) is followed by a correction circuit (14) which corrects each quotient supplied by the divider stage (12) by a correction value which depends at least on said quotient.

6. An arrangement as claimed in Claim 5, characterized in that the correction circuit (14) is a read-only memory having its address inputs coupled at least to the output of the divider stage (12) and having its data outputs coupled to the input of the second delay stage (20) and to one input of the second arithmetic stage (22, 28).

7. An arrangement as claimed in Claim 4, for carrying out the method as claimed in Claim 1, characterized in that

there is provided a first delay network (40) having a plurality of tappings (401, . . . 407) for delaying a plurality of data words and having its input coupled to the output of the second arithmetic unit (22, 28), which network takes over a data word in response to each zero-crossing signal and has its tappings (401, . . . 407) connected to the inputs of a multi-position switch (46),

there is provided a second delay network (42) having tappings (421, . . . 427) corresponding to those of the first delay network (40), which second delay network receives the zero-crossing signal and has its tappings (421, . . . 427) connected to a processing circuit (44) which, depending on the combination of signals on the tappings (421, . . . 427), generates a control signal to set the switch (46) to a position assigned to said combination, and

the input of the reciprocal-value generator (30) is coupled to the output of the switch (46).

8. An arrangement as claimed in Claim 7, characterized in that the first and the second delay network (40, 42) are constructed as shift registers comprising a plurality of stages (402, . . . 408; 422, . . . 428) which are clocked by the clock signal, each stage in the first delay network (40) storing a data word, and the tappings (401, . . . 407; 421, . . . 427) constitute the outputs of the individual stages (420, . . . 408; 422, . . . 428) and the input of the second delay network (42).

9. An arrangement as claimed in Claim 7 or 8, for carrying out the method as claimed in Claim 3, characterized in that the output of the switch (46) is connected to one input of a third arithmetic unit (50) which has another input coupled to the last tapping (407) of the first delay network (40) via a third delay stage (48), which delays each data word applied to it by one period of the clock signal, which third arithmetic unit supplies the difference between the two values applied to its two inputs to its output, the output of the third arithmetic stage (50) being coupled to a first input of a fourth arithmetic stage (54, 56) which, via a fourth delay stage (52) whose delay time is equal to the sum of the delay time of the first or the second delay network (40, 42) and that of the third delay stage (48), has a second input coupled to the output of the divider stage (12) or the following correction circuit (14), and which has a third input coupled to the output of the switch (46), and which, under control of the zero-crossing signal which has been delayed by the delay time of the first or the second delay network (40, 42), adds the product of the values applied to the first and the second input of the fourth arithmetic stage (54, 56) to the output signal of the

14

switch (46) in the clock period prior to the application of a new value to the output of the switch (46) and adds the value "0" to said output signal in the other clock periods, the sum being applied to the reciprocal-value generator (30).

10. An arrangement as claimed in Claim 9, characterized in that there is provided at least one switch (58) which is arranged before the first or the second input of the fourth arithmetic stage (54, 56) and which is controlled by the zero-crossing signal, which switch applies a data word of the value "0" to the relevant input in the absence of a zero-crossing signal.

11. An arrangement as claimed in any one of the Claims 4 to 10, characterized in that the reciprocal-value generator is a read-only memory having its address input connected to the output of the second (22, 28) or the fourth (54, 56) arithmetic stage and having its data output connected to the output (32) of the arrangement.

12. An arrangement as claimed in any one of the Claims 4 to 10, characterized in that for storing only those values which appear simultaneously with the zero-crossing signal the second delay stage (20) and/or the first stage (402) of the first delay network (40) comprise(s) a register stage (64) which is controlled by the clock signal and a second switch (62) which is controlled by the zero-crossing signal and which connects the output of the register stage (64) to the input of this stage in the absence of a zero-crossing signal.

Fig.1

Fig. 2

a)

Fig. 3

b)

c)

d)

e)

Fig. 4

Fig. 5

Fig. 6